# EUROPÄISCHE PATENTSCHRIFT

(11) **EP 0 895 512 B1**
(45) Veröffentlichungstag und Bekanntmachung des Hinweises auf die Patenterteilung: **20.10.1999**
(21) Anmeldenummer: 97923753.4
(22) Anmeldetag: 23.04.1997
(51) Int. Cl.: C04B 35/47, H01L 21/3205, H01L 27/115

(54) **PIN-SCHICHTENFOLGE AUF EINEM PEROWSKITEN**
PIN LAYER SEQUENCE ON A PEROVSKITE
SUCCESSION DE COUCHES PIN SUR UNE PEROVSKITE

(30) Priorität: 26.04.1996 DE 19616730; 01.07.1996 DE 19626343
(43) Veröffentlichungstag der Anmeldung: 10.02.1999
(73) Patentinhaber: FORSCHUNGSZENTRUM JÜLICH GMBH, 52425 Jülich (DE)
(72) Erfinder: SPEIER, Wolfgang, D-52428 Jülich (DE); SZOT, Krzysztof, PL-40-086 Katowice (PL)
(86) Internationale Anmeldenummer: DE9700822
(87) Internationale Veröffentlichungsnummer: WO9741081

(56) Entgegenhaltungen:
- US-A- 5 270 298
- US-A- 5 491 102

## Beschreibung

Die Erfindung bezieht sich auf ein Verfahren zur Herstellung einer Schichtenfolge, die eine mit AO angereicherte (ABO₃)-Schicht, eine B-oxidreiche Schicht sowie eine dazwischen befindliche ABO₃-Schicht aufweist. Sie bezieht sich ferner auf eine verfahrensgemäß hergestellte Schichtenfolge. A und B sind dabei die Elemente eines Perowskiten vom Typ ABO₃ (z. B. SrTiO₃, BaTiO₃, PbTiO₃ oder KNbO₃).

Die Erfindung bezieht sich ferner auf Vorrichtungen mit derartigen Schichtenfolgen.

Perowskite vom Typ ABO₃ werden als Substrat bei einkristallinem Schichtwachstum eingesetzt. Bekanntermaßen werden bei der Schichtherstellung die Schichten auf dem Substrat, also auf dem Perowskiten abgeschieden. Derartig hergestellte Schichtenfolgen werden z. B. für die Herstellung elektronischer Bauelemente benötigt.

Von Interesse sind in diesem Zusammenhang Schichtenfolgen, die pin-Übergänge aufweisen. P bedeutet p-leitende Schicht, n bedeutet n-leitende Schicht und Schicht i bedeutet Schicht mit intrinsischen Eigenschaften, d. h. die Schicht verfügt über Eigenleitung. An die eine Seite der Schicht mit der Eigenleitung grenzt also die p-leitende, an die andere Seite grenzt die n-leitende Schicht.

Aufgabe der Erfindung ist Schaffung von einfachen Verfahren zur Herstellung eines pin-Schichtsystems sowie die Bereitstellung eines verfahrensgemäß hergestellten Schichtsystems.

Die Aufgabe wird durch ein Verfahren mit den Merkmalen der Haupt- oder der nebengeordneten Verfahrensansprüche gelöst. Die Aufgabe wird ferner durch eine Vorrichtung mit den Merkmalen der nebengeordneten Ansprüche 8-10 gelöst. Vorteilhafte Ausgestaltungen ergeben sich aus den rückbezogenen Ansprüchen.

Im folgenden wird das Verfahren mit den Merkmalen des Hauptanspruchs sowie den hierauf rückbezogenen Ansprüchen erläutert.

Verfahrensgemäß wird eine pin-Schichtenfolge hergestellt, indem in einem Perowskiten vom Typ ABO₃ die AO-Schichten geeignet umgelagert (d. h. verlagert) werden. Diese Umlagerung bewirkt, daß in den Bereichen, aus denen AO-Schichten verlagert (d. h. entfernt) wurden, sich B-oxidreiche Schichten gemäß BO_{2,} BₙO₂ₙ₋₁ oder BO₂•(ABO₃)ₙ) ausbilden. In die Bereiche, in die AO-Schichten hineinverlagert wurden, entstehen Schichten mit AO•(ABO₃)ₘ -Struktur. Dazwischen verbleibt eine Schicht mit ABO₃-Struktur.

Die ABO₃-Schicht ist die Schicht mit der Eigenleitung. Die ABO₃-Schicht ist ein Halbleiter mit einer breiten Bandlücke oder ein Isolator mit schmaler Bandlücke. Die B-oxidreiche Schicht ist die Schicht mit n-leitender Eigenschaft. Die AO•(ABO₃)ₘ -Schicht weist p-leitende Eigenschaften auf.

Die B-oxidreiche Schicht weist bei weiterer Reduktion semimetallische Eigenschaften auf.

Eine anspruchsgemäße Umlagerung von AO Schichten wird insbesondere bewerkstelligt, indem der Perowskit oxidierenden oder reduzierenden Bedingungen ausgesetzt wird. Dies wird vorzugsweise durch ein Verfahren mit den Merkmalen des rückbezogenen Verfahrensanspruchs erreicht.

Unter Defektchemiediagramm wird die Defektkonzentration als Funktion des Sauerstoffpartialdruckes (p_{O₂}) verstanden. Hierfür wird ein Diagramm erstellt, bei dem die elektrische Leitfähigkeit des Perowskiten gegen den Sauerstoffpartialdruck isotherm (Temperatur T = konstant) aufgetragen wird.

Kristalle oder dünne kristallische Schichten von Perowskiten des ABO₃-Typs werden bei Temperaturen oberhalb von 500°C unter kontrollierten atmosphärischen O₂-Bedingung für eine bestimmte Zeit behandelt (Behandlungszeit). Unter solchen Bedingungen stellt sich an der Oberfläche des Ausgangsmaterials eine Oberflächenregion ein, die aus Schichten (Multilayer) mit unterschiedlicher chemischer Zusammensetzung senkrecht zur Oberfläche (entlang der Oberflächennormalen) zusammengesetzt ist.

Bei hohem Sauerstoffpartialdruck (oxidierende Bedingungen: pO₂ abhängig von Temperatur, muß oberhalb des Minimums der entsprechenden Isotherme im Defektchemiediagramm liegen) bildet sich folgende Schichtenfolge - von der Oberfläche her gesehen - aus:
Die oberste Schicht hat eine Struktur der allgemeinen Form AO•(ABO₃)ₘ. An der Oberfläche ist das kleinste m zu finden und steht in direktem Kontakt mit dem atmosphärischen O₂ (m=1 ist bei geeignetem p_{O₂} und geeigneter Behandlungszeit erreichbar). Mit zunehmender Schichttiefe des kristallinen Materials nimmt m zu, bis die Schicht dem intrinsischen ABO₃-Typ entspricht. In noch tieferen Lagen bildet sich Strukturen, die durch Anreicherung von Oxiden mit dem Element B entsteht (z.B. BO_{2,} BₙO₂ₙ₋₁, BO₂•(ABO₃)ₙ). Die Dicke des Multilayer-Schichtsystem hängt von der Behandlungszeit und -temperatur ab. Der Übergang zwischen den Bereichen verschiebt sich mit Temperatur und Zeit in tiefere Bereiche der Oberflächenregion (Beispiel: nach 1 Stunde Behandlungszeit bei Temperaturen von 850 - 900 °C, einem Sauerstoffpartialdruck von 10² Torr des Perowskiten SrTiO₃ entsteht eine ca. 100 nm Oberflächenregion bzw. Multilayerschicht mit pin-Übergängen). Die Dicke der intrinsischen Schicht betrug typischerweise weniger als 20% der Dicke der SrO•(SrTiO₃)ₘ-Schicht.

Die einzelnen Schichten sind unterschiedlich in ihren elektrischen und dielektrischen Eigenschaften. Die obere AO•(ABO₃)ₘ-schicht verhält sich wie ein p-Leiter, die unterste Schicht mit B-Oxiden zeigt Eigenschaften eines n-Leiters. Die beiden Schichten sind durch eine dünne Schicht mit intrinsischen Eigenschaften (i) des Ausgangsmaterials getrennt. Es formiert sich also eine Schichtenfolge mit pin-Struktur (pin-Übergänge) von der Oberfläche aus betrachtet aus. Regelmäßig liegt die Dicke der Schicht mit den intrinsischen Eigenschaften unter 20% der p-leitenden Oberflächenschicht.

Bei niedrigem Sauerstoffpartialdruck, d. h. bei reduzierenden Bedingungen (der von der Temperatur (T) abhängige Sauerstoffpartialdruck p_{O₂}(T) muß unterhalb des Minimums der zugehörigen Isotherme im Defektchemiediagramm liegen) bildet sich die umgekehrte Sequenz der Schichten von der Oberfläche aus gesehen aus:
Die obere Schicht ist ein B-reiches Oxid. Die Zwischenschicht entspricht dem ursprünglichen ABO₃-Material. Die unterste Schicht hat wieder die allgemeine Struktur AO•(ABO₃)ₘ. Die Dicke der ABO₃ -Schicht liegt bei unter 20% der oberen Schicht mit angereichertem Sauerstoff.

Dieses Schichtsystem zeigt von der Oberfläche her betrachtet eine nip-Struktur.

Bei reduzierenden p_{O₂}-Bedingungen und Temperaturen oberhalb von 500 °C wird mit zunehmender Behandlungsdauer die obere Schicht von der Oberfläche her zunehmend reduziert, d.h. Sauerstoff wird an die Atmosphäre abgegeben und sauerstoffarme B-oxide bilden sich infolgedessen. Die oberste Schicht zeigt semimetallische Eigenschaften (s) an der Oberfläche zeigen. Es läßt sich auf diese Weise eine snip-Struktur bilden. Nach Abkühlen wird die semimetallische Schicht teilweise wieder mit Sauerstoff beladen.

Zur Herstellung lokal begrenzter Bereiche mit pin-Übergängen an der Oberfläche des Perowskiten, wird der lokale Bereich stärker erhitzt als seine Umgebung. Diese lokale Erhitzung wird beispielsweise mittels Laser durchgeführt. Wird nun der Perowskit reduzierenden oder oxidierenden Bedingungen ausgesetzt, so findet die Umlagerung (zunächst) nur im lokal erhitzten Bereich statt. Auf diese Weise lassen sich pin-Strukturen an der Oberfläche eines Perowskiten herstellen.

Z. B. wird der Perowskit auf eine Temperatur von 500 °C erhitzt. Lokal begrenzt wird der Perowskit mit Laser derart bestrahlt, daß hierdurch an der bestrahlten Stelle Temperaturen von 600 °C entstehen. Anschließend wird ein Sauerstoffpartialdruck von z. B. 13,3 KPa (10² Torr) erzeugt. Es entsteht dann nur innerhalb des bestrahlten Bereiches eine pin-Schichtenfolge von der Oberfläche her betrachtet.

Zur Erzeugung von pin-Strukturen von der Oberfläche her betrachtet werden grundsätzlich Temperaturen zwischen 500-1000 °C und Sauerstoffpartialdrücke von 133-133.10³ Pa (1-1000 Torr) eingestellt. Vorzugsweise wird der Perowskit zur Vermeidung von mechanischen Spannungen im Anschluß langsam abgekühlt.

Zur Erzeugung von nip-Strukturen von der Oberfläche her betrachtet werden grundsätzlich die gleichen Temperaturen wie vor gewählt und Sauerstoffpartialdrücke im Bereich von 0,133-1,33·10⁻¹⁰ Pa (10⁻³ bis 10⁻¹² Torr) eingestellt. Vorzugsweise wird nach der Behandlung langsamer als 100 °C/min zur Vermeidung von Komplexbildungen abgekühlt.

Ausführungsbeispiele für Verfahren mit den Merkmalen des Haupt- oder der hierauf rückbezogenen Ansprüche sind:
SrTiO₃ oder BaTiO₃ mit einer Beimischung von Fe oder W (20 ppm) werden in (100)-Richtung orientiert, poliert, geätzt und gespült. Sie werden dann eine Stunde lang auf 850 - 900 °C bei einem Sauerstoffpartialdruck von 10² Torr erhitzt. Anschließend werden sie langsam abgekühlt (z. B. langsamer als 10 °C/min), um mechanische Spannungen zu vermeiden. Es entstehen an der Oberfläche pin-Schichtenfolgen von der Oberfläche her betrachtet. Die Gesamtdicke liegt dann bei ca. 100 nm.

Die vorgenannten Perowskite werden in einem zweiten Fall in gleicher Weise präpariert und auf 500 °C erhitzt. Lokal wird die Oberfläche mittels Laser auf 600 °C erhitzt. Es wird dann der vorgenannte Sauerstoffpartialdruck eine Stunde lang erzeugt. Anschließend wird langsam abgekühlt. Nur innerhalb des mittels Laser erhitzten Bereiches tritt dann die pin-Schichtenfolge auf.

In gleicher Weise wird an den Oberflächen von KNbO₃- oder PbTiO₃-Perowskiten pin-Schichtenfolgen - von der Oberfläche her betrachtet - erzeugt. Die Temperaturen liegen jedoch während der Behandlungszeit unterhalb von 750 °C. Höhere Temperaturen würden nachteilhaft das Aufdampfen von K₂O bzw. PbO-Komplexen bewirken.

Zur Herstellung von 100 nm-dicken nip-Schichtenfolgen (von der Oberfläche her betrachtet) in den vorgenannten Perowskiten werden Temperaturen wie vorgenannt gewählt. Es wird ein Sauerstoffpartialdruck von 1,33·10⁻⁷ Pa (10⁻⁹ Torr) erzeugt. Die Behandlungszeit beträgt 2 Stunden. Es wird sehr schnell abgekühlt (z. B. schneller als 100°C/min), um nachteilhafte Oxidationseffekte zu vermeiden.

Im folgenden wird das Verfahren mit den Merkmalen des nebengeordneten Verfahrensanspruch sowie den hierauf rückbezogenen Ansprüchen erläutert.

Als Perowskit kann sowohl ein Kristall als auch eine Keramik eingesetzt werden. Verfahrensgemäß fließt zunächst durch den Perowskiten ein konstanter Gleichstrom. Dies wird beispielsweise bewirkt, indem von beiden Seiten des Perowskiten mittels aufgebrachter Elektroden eine entsprechend variierende Spannung angelegt wird.

Die Einhaltung eines genügend konstanten Gleichstromes ist notwendige Voraussetzung zur Herstellung der gewünschten Schichtenfolge. Äquivalente Maßnahme ist das Fließen eines näherungsweise konstanten Gleichstroms, der ausreichend konstant ist, um die gewünschte Schichtenfolge entstehen zu lassen.

Zur Vermeidung lokaler Überhitzung sollte die Stromstärke vorzugsweise 50 mA/cm² nicht übersteigen.

Unter Vakuumbedingungen kann zur Erzeugung des Stromdurchflusses alternativ der Perowskit mit Elektronen beschossen werden.

Der Stromfluß durch den Perowskiten führt zu einer Elektromigration der Sauerstoffionen. Diese Migration findet bei Einkristallen bevorzugt entlang 2-3dimensionaler Defekte (sogenannte ausgedehnte Defekte) im Perowskiten statt. Die Sauerstoffionen wandern von der Kathode in Richtung Anode (im Falle der Stromflußerzeugung mittels zweier am Perowskiten angebrachten Elektroden).

Die Elektromigration verursacht die Bildung von einem chemischen Sauerstoffkonzentrationsgradienten in der Nähe der Anode. Hierdurch wird eine zusätzliche Segregation von AO-Komplexen bewirkt. Unter der Anode (entsprechendes gilt bei Beschuß mit Elektronen) entsteht eine pin-Schichtenfolge, d.h., von der Oberfläche her betrachtet, liegt zunächst eine p-leitende Schicht (angereichert mit AO-Komplexen) vor. Darunter befindet sich eine Schicht mit Eigenleitung. Unter der eigenleitenden Schicht hat sich eine Schicht mit n-leitenden Eigenschaften ausgebildet. In der n-leitenden Schicht liegen BO-artige Komplexe im Überschuß vor.

Unter der Kathode (entsprechendes gilt bei Beschuß mit Elektronen) bildet sich eine snip-Struktur aus. Von der Oberfläche her betrachtet liegt dann zunächst eine semimetallische Schicht vor. Darunter befindet sich eine Schicht mit n-leitenden Eigenschaften. Unter der n-leitenden Schicht befindet sich eine Schicht mit der Eigenleitung. Darunter befindet sich eine Schicht mit p-leitenden Eigenschaften.

In der zuletzt genannten Schichtenfolge bildet sich zuoberst eine semimetallische Schicht, weil die AO-arme, n-leitende Schicht an ihrer Oberfläche reduziert wird. Diese Reduktion führt zur Bildung der Schicht mit semi-metallischen Eigenschaften.

Die snip-Struktur unterhalb der Kathode bildet sich insbesondere in der Nähe von ausgedehnten Defekten aus. Durch die gute elektrische Leitfähigkeit (aufgrund der s-Schicht) bei den ausgedehnten Defekten an der Perowskitoberfläche vergrößert sich die effektive Oberfläche als Elektrodenkontakt. Diese vergrößerte effektive Oberfläche kann als virtuelle Elektrode angesehen werden.

Werden z. B. bei Temperaturen zwischen 300 - 400°C ein Strom in der Größenordnung einige mA/cm² durch den Perowskiten für einige Stunden hindurchgeleitet, so entsteht an einer Seite eine pin-Schicht sowie auf einer anderen Seite eine snip-Schicht in einer Dicke von einigen nm.

Werden die Elektroden entfernt oder abgeätzt bzw. der Elektronenbeschuß eingestellt, so wandelt sich die semimetallische Schicht von der Oberfläche her betrachtet durch teilweise Oxidation um.

Je größer die ionische Leitfähigkeit im Perowskiten ist, desto schneller bilden sich die gewünschten Schichtenfolgen. Bevorzugt ist daher die Temperatur des Perowskiten bei Stromdurchgang so zu wählen, daß die Überführungszahl (die ein Maß für die ionische Leitfähigkeit darstellt) groß ist. Unter großer Überführungszahl sind insbesondere solche oberhalb von 0,2 zu verstehen.

Ist ein in Form einer dünnen Schicht von einigen 100 nm ausgestalteter Perowskit verfahrensgemäß (bezogen auf ein Verfahren mit den Merkmalen des Nebenanspruchs) behandelt worden, so ist nach Herstellung der pin- bzw. snip-Strukturen die Kapazität gegenüber dem unbehandelten Perowskiten deutlich erhöht.

Des weiteren weisen dünne Schichten, die erfindungsgemäß behandelt worden sind, anschließend einen positiven Temperaturkoeffizienten auf. Unter positiven Temperaturkoeffizienten wird verstanden: Es gibt einen Temperaturbereich, innerhalb der der Perowskit mit steigender Temperatur einen steigenden Widerstandsverlauf zeigt.

Elektroden wurden beispielsweise auf die (100)-Oberfläche eines handelsüblichen SrTiO₃-Kristalls mit einer Dicke von 1 mm aufgedampft. Der Kristall mit den aufgetragenen Elektroden wurde auf 330 °C erhitzt. Ein konstanter Stromfluß von ca. 50 mA/cm² durch den Kristall hindurch wurde dann für 2 Stunden erzeugt. Anschließend wurde der Kristall auf Raumtemperatur abgekühlt und die Elektroden abgeätzt.

Auf diese Weise wurden die vorgenannten Schichtenfolgen hergestellt.

Das Verfahren wurde erfolgreich u. a. angewendet auf: BaTiO₃-Keramik, SrTiO₃-Keramik dotiert mit 0,3 % Fe, AgNbO₃-Keramik, KNbO₃-Keramik, NaNbO₃-Keramik, PbZrO₃-Keramik sowie auf derartige Einkristalle.

Die Behandlungstemperaturen lagen zwischen 300 und 500 °C. Die Stromstärke betrug weniger als 50 mA/cm². Die Behandlungsdauer varrierte. Sie hing insbesondere bei Keramiken von der Dichte und Korngröße des Materials ab.

Zu lange Behandlungszeiten führten einen Kurzschluß, also eine durchgehende s-Schicht herbei.

Verfahren mit den Merkmalen der Haupt- oder Nebenansprüche bewirken die Herstellung eines Perowskiten mit den Merkmalen des nebengeordneten Anspruchs 8. Die mit AO angereicherte Schicht ist p-leitend. Die BO-reiche Schicht ist n-leitend. Die dazwischen befindliche ABO₃-Schicht weist die Eigenleitung auf.

Im folgenden wird ein elektronisches Bauelement, welches einen Perowskiten vom Typ ABO₃ mit einer der vorgenannten Schichtenfolgen aufweist, an einem Beispiel erläutert.

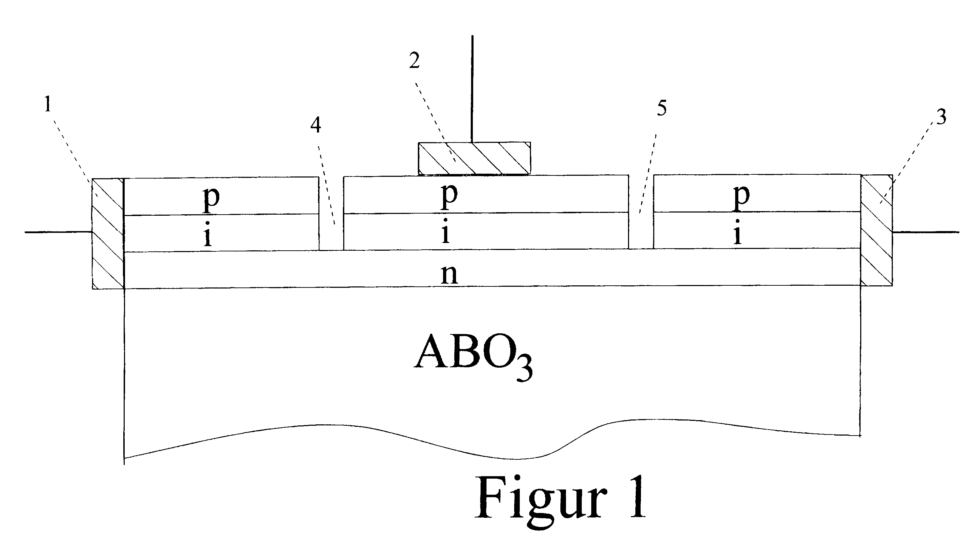

Figur 1 zeigt einen Schnitt durch ein elektronisches Bauelement, das einen Perowskiten vom Typ ABO₃ mit anspruchsgemäßen Vorrichtungsmerkmalen aufweist.

Im Oberflächenbereich eines Perowskiten vom Typ ABO₃ wurde eine pin-Schichtenfolge erzeugt. Der Perowskit wurde anschließend so präpariert, daß Elektroden 1 und 3 in der aus der Figur 1 ersichtlichen Weise derart angebracht werden konnten, daß diese die pin-Schichtenfolge an entgegengesetzten Enden kontaktieren. Mittels eines Ätzvorgangs wurden zwei bis zur n-Schicht reichende Gräben 4 und 5 hergestellt. Diese Gräben 4 und 5 unterbrechen die p- und die i-Schicht. Auf der zwischen den Gräben 4 und 5 befindlichen p-Schicht wurde eine Elektrode 2 angebracht.

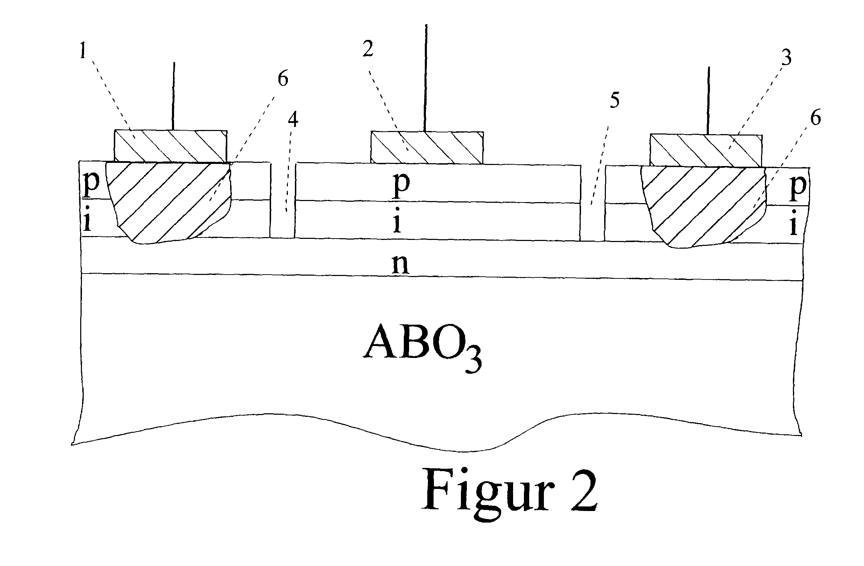

Eine Kontaktierung der in Figur 1 mit 1 und 3 gekennzeichneten Elektroden kann alternativ in der aus Figur 2 ersichtlichen Weise erfolgen, wenn die unter den Elektroden 1 und 3 befindlichen p und i-Schichten vor der Anbringung der Elektroden 1 und 3 in n-leitende oder semimetallische Bereiche 6 umgewandelt worden sind. Diese Umwandlung kann durch Elektronenbeschuß erfolgen.

Das in den Figuren im Schnitt gezeigte elektronische Bauelement wird als Transistor eingesetzt.

## Patentansprüche

1. Verfahren zur Herstellung einer pin-Schichtenfolge, indem AO-Schichten in einem Perowskiten vom Typ ABO₃ derart umverlagert werden, daß eine p-leitende AO•(ABO₃)ₘ-, eine n-leitende B-oxidreiche sowie eine dazwischen befindliche eigenleitende ABO₃-Schicht entsteht.

2. Verfahren nach vorhergehendem Anspruch, bei die Umverlagerung erfolgt, indem der Perowskit vom Typ ABO₃ oxidierenden oder reduzierenden Bedingungen ausgesetzt wird.

3. Verfahren nach vorhergehendem Anspruch, bei dem der Perowskit bei einer oberhalb von 500 °C liegenden Temperatur T₀ einem Sauerstoffpartialdruck ausgesetzt wird, der oberhalb oder unterhalb des Minimums der Isotherme der Temperatur T₀ im Defektchemiediagramm liegt.

4. Verfahren zur Herstellung einer pin-Schichtenfolge auf der Oberfläche eines Perowskiten vom Typ ABO₃, indem durch den Perowskiten ein konstanter Gleichstrom zur Ausbildung der herzustellenden Schichtenfolge hindurchgeleitet wira.

5. Verfahren nach vorhergehendem Anspruch,
**dadurch gekennzeichnet, daß**
die Stromstärke des Gleichstroms weniger als 50 mA/cm² beträgt.

6. Verfahren nach einem der vorhergehenden Ansprüche,
**dadurch gekennzeichnet, daß**
der Strom wenigstens eine Stunde durch den Perowskiten fließt.

7. Verfahren nach einem der vorhergehenden Ansprüche,
**dadurch gekennzeichnet, daß**
der Stromfluß bei Temperaturen durchgeführt wird, die Überführungszahlen größer als 0,2 bezüglich ionischer Leitfähigkeit im Perowskiten bewirken.

8. Perowskit vom Typ ABO₃ mit einer Schichtenfolge auf seiner Oberfläche, die eine mit AO angereicherte (ABO₃)-Schicht, eine B-oxidreiche Schicht sowie eine dazwischen befindliche ABO₃-Schicht aufweist

9. Perowskit nach Anspruch 8 mit einer Schichtenfolge auf seiner Oberfläche, bei der die mit AO angereicherte (ABO₃)-Schicht in Form einer AO•(ABO₃)ₘ-Schicht vorliegt.

10. Perowskit nach vorhergehendem Anspruch, bei dem die Oberfläche des Perowskiten eine Orientierung {1,0,0} aufweist.

11. Elektronisches Bauelement, das einen Perowskiten vom Typ ABO₃ mit den Merkmalen nach einem der vorhergehenden Ansprüche 8-10 aufweist.

## Claims

1. A process for producing a pin layer sequence by rearranging AO layers in a perovskite of the ABO₃ type in such a way that a p-conducting AO^{·}(ABO₃)ₘ layer, an n-conducting layer rich in B oxide, and an intrinsically conducting ABO₃ layer situated therebetween are formed.

2. A process according to the preceding claim, wherein rearrangement is effected by subjecting the perovskite of the ABO₃ type to oxidising or reducing conditions.

3. A process according to the preceding claim, wherein the perovskite is subjected, at a temperature T₀ which is above 500°C, to an oxygen partial pressure which is above or below the minimum of the isotherm at temperature T₀ in the defect chemistry diagram.

4. A process for producing a pin layer sequence on the surface of a perovskite of the ABO₃ type by passing a constant direct current through the perovskite in order to form the layer sequence to be produced.

5. A process according to the preceding claim, characterised in that the current strength of the direct current is less than 50 mA/cm².

6. A process according to any one of the preceding claims, characterised in that the current flows through the perovskite for at least one hour.

7. A process according to any one of the preceding claims, characterised in that the current flow is effected at temperatures which result in transport numbers greater than 0.2 with respect to ionic conductivity in the perovskite.

8. A perovskite of the ABO₃ type, having a layer sequence on its surface which comprises an (ABO₃) layer enriched in AO, a layer rich in B oxide, and an ABO₃ layer situated therebetween.

9. A perovskite according to claim 8, having a layer sequence on its surface wherein the (ABO₃) layer which is enriched with AO is present in the form of an AO^{·}(ABO₃)ₘ layer.

10. A perovskite according to the preceding claim, wherein the surface of the perovskite has a {1,0,0} orientation.

11. An electronic component which comprises a perovskite of the ABO₃ type having the features according to any one of the preceding claims 8-10.

## Revendications

1. Procédé de fabrication d'une séquence de couches pin, dans laquelle des couches d'AO sont déplacées, dans une perowskite de type ABO₃, de façon qu'il se crée une couche d'AO•(ABO₃)ₘ- à conduction p, une couche à haute teneur en oxyde de B et à conduction n, ainsi qu'une couche d'ABO₃, à conduction propre, disposée entre ces deux dernières.

2. Procédé selon la revendication précédente, dans laquelle un déplacement a lieu par exposition de la perowskite de type ABO₃ à des conditions oxydantes ou réductrices.

3. Procédé selon la revendication précédente, dans lequel la perowskite est exposée à une température T₀ supérieure à 500°C et à une pression partielle d'oxygène qui est supérieure ou inférieure au minimum de l'isotherme de la température T₀ dans le diagramme de chimie des défauts.

4. Procédé de fabrication d'une séquence de couches pin sur la surface d'une perowskite de type ABO₃, dans lequel on fait passer par la perowskite un courant continu constant, pour réaliser la séquence de couches à fabriquer.

5. Procédé selon la revendication précédente, caractérisé en ce que la densité du courant continu est inférieure à 50 mA/cm².

6. Procédé selon l'une des revendications précédentes, caractérisé en ce que le courant passe pendant au moins une heure dans la perowskite.

7. Procédé selon l'une des revendications précédentes, caractérisé en ce qu'on procède au passage du courant à des températures conduisant à des coefficients de transfert supérieurs à 0,2 par rapport à la conductivité ionique.

8. Perowskite du type ABO₃, comportant une séquence de couches sur sa surface, qui comporte une couche d'ABO₃ enrichie en AO, une couche riche en oxyde de B, ainsi qu'une couche d'ABO₃ disposée entre elles.

9. Perowskite selon la revendication 8, comportant une séquence de couches sur sa surface, dans laquelle la couche d'ABO₃ enrichie en AO se présente sous forme d'une couche d'AO•(ABO₃)ₘ-.

10. Perowskite selon la revendication précédente, dans laquelle la surface de la perowskite présente une orientation {1,0,0}.

11. Composant électronique, qui comporte une perowskite de type ABO₃ présentant les caractéristiques selon l'une des revendications 8 à 10.
